# EUROPEAN PATENT SPECIFICATION

(11) **EP 1 493 313 B1**
(45) Date of publication and mention of the grant of the patent: **29.11.2006**
(21) Application number: 03718025.4
(22) Date of filing: 24.03.2003
(51) Int. Cl.: H05K 3/28

(54) **WATERBORNE PRINTED CIRCUIT BOARD COATING COMPOSITIONS**
WÄSSRIGE BESCHICHTUNGSZUSAMMENSETZUNGEN FÜR LEITERPLATTE
COMPOSITIONS AQUEUSES DE REVETEMENT DE CARTES A CIRCUIT IMPRIME

(30) Priority: 11.04.2002 US 371498 P
(43) Date of publication of application: 05.01.2005
(73) Proprietor: SI Group, Inc., Schenectady, NY 12309 (US)
(72) Inventor: BAUGHMAN, Donald, Richard, Havre De Grace, Maryland 21078 (US); KLEIN, Jon, Christopher, Scotia, NY 12302 (US); LEONARD, James, Dennis, Salem, NY 12865 (US); ROBIDEAU, Gary, Joseph, Niskayuna, NY 12309 (US)
(74) Representative: Raynor, John
(86) International application number: PCT/US2003/008838
(87) International publication number: WO 2003/087937

(56) References cited:
- WO-A-01/25314
- GB-A- 2 261 664
- US-A- 5 506 089

## Description

### Cross-reference to Related Applications

The present application is related to U.S. provisional application 60/371,498, which was filed on April 11, 2002.

### Field of the Invention

The present invention relates to waterborne compositions for coating printed circuit boards.

### Background of the Invention

Photoimageable and/or thermally curable compositions comprising organic solvents, such as photoresists and solder resists, used in the manufacture of printed circuit boards ("PCB's"), are a well established technology. Examples are disclosed in, for instance, US Patent 4,933,259 and US Patent 5,009,982. These conventional compositions, however, include a substantial amount of organic solvent.

Attempts to increase worker safety and environmental conditions by reducing and/or eliminating the use of the organic solvent vehicle from photoimageable and/or thermally curable compositions have not produced a viable alternative to the organic solvent-containing compositions. US Patents 5,093,223 and 5,439,779 discuss the use of waterborne photoimageable and thermally-cured systems specific to the manufacture of PCB's, but these materials are characterized by slow processing times. US Patent 4,548,890 mentions a waterborne photoimageable and thermally-cured system not specific to the manufacture of PCB's. US Patents 5,501,942, 5,925,499, and 5,656,411 exemplify waterborne photoimageable PCB's, but utilize conventional surfactants and/or neutralized acrylic-type binder resins. Document GB-A-2 261 664 discloses a coating composition for printed circuit board based on epoxy resin and polyester surfactant. The use of conventional surfactants and/or neutralization to stabilize waterborne photoimageable and/or thermally curable compositions can lead to poor material stability, as well as deficient application and final properties.

Specifically, conventional surfactants and/or neutralization depend upon the inherently-weak hydrophobic interaction between surfactant and the organic phase. This interaction can be detrimentally affected by storage, high shear, ionic species, pH changes, and temperature changes. Conventional surfactants increase the moisture sensitivity of the final film due to phase separation of the surfactant out of the polymer matrix during film coalescence. The resulting surfactant-rich sites can produce poor performance characteristics such as blooming and high water uptake which would detrimentally affect the coating during the image development and/or hot-air solder leveling steps of PCB manufacturing.

Conventional surfactants and/or neutralization may reduce the gloss of the dry film, enhance dirt pickup and whiten the final film in humid conditions. The immiscibility of the hydrophobic polymer and hydrophilic surfactant causes the surfactant migration to the film surface resulting in poor gloss and surface tackiness. Leveling of the film surface is hindered and a rough, cratered surface results once the surfactant is washed off. Rapid whitening or blooming of the dry film in humid conditions due to water absorbing in microvoids in the bulk of the film can occur. Finally, as the water swells the final film and diffuses throughout the coating, surfactant migration to the coating-substrate interface may cause adhesion failure and coating delamination.

It is an objective of the present invention to provide waterborne printed circuit board coating compositions that overcome one or more of the above-noted problems associated with conventional waterborne compositions and conventional surfactants.

### Summary of the Invention

The present invention provides waterborne printed circuit board coating compositions comprising polyether surfactants that can bind into the polymeric network that is formed upon curing the printed circuit board coating compositions. For instance, the present invention provides waterborne printed circuit board compositions comprising one or more polyether surfactants that comprise a photoreactive group, a thermosetting group, and/or a group that is capable of reacting with one of the photoreactive or thermosetting components present in the printed circuit board composition. Furthermore, the present invention provides self-emulsifiable thermosetting components and self-emulsifiable photoreactive components, preferably for use in waterborne printed circuit board coating compositions.

In one embodiment, the present invention provides waterborne printed circuit board compositions comprising one or more of the following components (1)-(3):
(1) a thermosetting component comprising
   one or more thermosetting groups; and
   a polyether surfactant;
(2) a photoreactive component comprising
   at least two ethylenically unsaturated groups; and
   a polyether surfactant;

For instance, the present invention provides waterborne printed circuit board compositions comprising:
(a) a thermosetting component comprising a polyether surfactant grafted onto the backbone of said component;
(b) a photoreactive component comprising at least two ethylenically unsaturated groups and a polyether surfactant grafted onto the backbone of said component;
(c) one or more photoinitiators; and
(d) water.

Another example of a printed circuit board coating composition provided by the present invention is a composition comprising:
(a) a thermosetting component;
(b) a photoreactive component;
(c) one or more photoinitiators;
(d) water; and
(e) a polyether surfactant comprising one or more epoxy-reactive groups.

### Detailed Description of the Invention

### Definitions/Preliminary Remarks:

Printed circuit board ("PCB") coating composition refers herein to solder resists and etching resists for printed circuit board applications.

The "total weight of solids" refers herein to the total weight of the composition minus the weight of water that is present in the composition.
"(meth)acrylate" refers herein to "methacrylate and/or acrylate".

The ingredients for the present compositions may be provided in a one-part system or in multi-part systems. Multi-part systems, for instance two-part systems, are preferred. Multi-part systems are, for instance, advantageous to improve shelf life by separating reactive ingredients. For instance, if the compositions comprise both epoxy-functional components and epoxy curing agents, it is often advantageous to store the ingredients for the composition as a two (or more) part system, with one part comprising the epoxy-functional component and another part comprising the epoxy curing agent. The coating composition can then be formed by mixing the parts shortly before use.

The present invention provides waterborne printed circuit board coating compositions that preferably comprise at least one of the following ingredients:
(1) a thermosetting component comprising
   one or more thermosetting groups; and
   a polyether surfactant;
(2) a photoreactive polymer comprising
   at least two ethylenically unsaturated groups; and
   a polyether surfactant;

In one embodiment, the present compositions comprise at least the following components:
(a) one or more thermosetting components, including for instance above-noted thermosetting component (1);
(b) one or more photoreactive components, including for instance above-noted photoreactive component (2);
(c) one or more photoinitiators;
(d) water;
(e) optionally, a polyether surfactant comprising one or more epoxy-reactive groups; and
(f) optionally, additives.

### (a) thermosetting components

The present compositions preferably comprise one or more thermosetting components. Preferably, the present compositions comprise an epoxy-functional component (*i.e.* a component comprising an epoxy group), more preferably a polyepoxide component (*i.e.* a component comprising on average at least two epoxy groups, for instance at least three epoxy groups).

Epoxides that may be used include, for instance, the glycidyl ethers of both polyhydric phenols and polyhydric alcohols, epoxidized fatty acids or drying oil acids, epoxidized diolefins, epoxidized di-unsaturated acid esters, epoxides comprising one or more (preferably 2) cyclohexeneoxide groups, and epoxidized unsaturated polyesters.

Preferred epoxides include those having a weight average molecular weight of at least 500 g/mol, for instance at least 750 g/mol or at least 1250 g/mol. Generally, the weight average molecular weight will be below 30,000 g/mol. In certain embodiments it is also preferred that the epoxy resins comprise at least one aromatic ring, for instance at least two aromatic rings or at least 4 aromatic rings.

Particularly preferred epoxy resins include bisphenol A epoxy resins, bisphenol F epoxy resins, tetraphenolethane epoxy resins, phenolic novolac epoxy resins, bisphenol A novolac epoxy resins, cresol (e.g. o-cresol) epoxy novolac epoxy resins, trisphenol novolac epoxy resins, and cycloaliphatic epoxy resins.

Most preferred are the above-mentioned epoxy novolac components. Preferably the epoxy novolacs comprise on average 3-15 epoxy groups per molecule, more preferably 3-10 epoxy groups, and most preferably 4-8 epoxy groups.

### (a1) thermosetting polymer comprising a polyether surfactant

It is preferred that the present compositions comprise at least one epoxy-functional component having at least one polyether surfactant grafted onto the component. For instance it is preferred that the compositions comprise an epoxy novolac having at least on polyether surfactant grafted onto the novolac backbone. Having one or more polyether surfactants attached to the epoxy ensures that the surfactant can become part of the polymeric network upon curing, and hence surfactant migration to the surface of a cured product can be avoided. Furthermore, with one or more polyether surfactants grafted onto the epoxy, the epoxy can become self-emulsifiable (i.e. the epoxy doesn't require additional "free" surfactant to be emulsified or finely dispersed in a solution).

It is preferred that the polyether surfactants are grafted onto the epoxy component by reacting the surfactant with one of the epoxy groups of the epoxy component. Accordingly, the polyether surfactants used for grafting are preferably epoxy-reactive surfactants.

Preferred epoxy-reactive surfactants are polymeric epoxy-reactive polyether surfactants. Preferred polyether surfactants include those that consist for at least 60 wt% of ether moieties, more preferably at least 75 wt%, and most preferably at least 90 wt%.

The epoxy-reactive polyethers may be homopolymers or copolymers. Preferred homopolymers include polyethylene oxide, polypropylene oxide, and polybutylene oxide. The epoxy-reactive polyethers copolymers may also be random copolymers or block copolymers. Preferred copolymers include poly(ethylene oxide-propylene oxide) and poly(ethylene oxide-polybutylene oxide) copolymers. Preferably the epoxy-reactive polyether copolymers are block copolymers.

Preferably the polyether surfactant comprises at least one terminus with isocyanate, hydroxyl, methoxy, and/or carboxylic acid functionality, more preferably at least one terminal carboxylic acid group or isocyanate group. The polyether may, for instance, be terminated at both ends of the polyether chain with a carboxylic acid group. Accordingly, suitable polyether surfactants include those represented by the following formula (I):

HOOC-(O-R¹)ₙ-(O-R²)ₘ-COOH (I)

wherein
R¹ and R² each represent a substituted or unsubstituted C₁-C₁₀, preferably C₂-C₄, alkyl group;
R¹ and R² do not represent the same group;
n represents an integer of 0-1000;
m represents an integer of 0-1000; and
n+m = at least 20, preferably at least 50, more preferably at least 100.

More preferred are polyether surfactants having only one epoxy-reactive group, more preferably one terminal epoxy-reactive group, such as a terminal carboxylic acid or isocyanate group. Suitable polyethers comprising only one epoxy-reactive acid group may be obtained, for instance, by reacting a polyether diol with a carboxylic anhydride (for instance tetrahydrophtalic anhydride) or a polyisocyanate (*e.g.* isophorone diisocyanate or toluene diisocyanate). Examples of suitable commercial diols include, for instance, Pluronics F-88 (ethylene-oxide propylene oxide block copolymer commercially available from BASF, Mw = 11,000 g/mol).

The weight average molecular weight of the polyether surfactants (prior to grafting onto the epoxy-functional component) is preferably in the range of 500-50,000 g/mol, more preferably 1,000-20,000 g/mol, e.g. 1,000-15,000 g/mol or 5,000-20,000 g/mol.

Preferably, the present compositions comprise, relative to the total weight of solids, 5-60 wt% of components having one or more epoxy groups, more preferably 5-40 wt%, and most preferably 5-15 wt%.

### (b) Photoreactive component

The present compositions generally comprise one or more photoreactive components. Preferably, the one or more photoreactive components include a photoreactive component comprising at least one ethylenically unsaturated group, more preferably at least two ethylenically unsaturated groups. The amount of ethylenically unsaturated groups will generally be less than 12. Preferred ethylenically unsaturated groups include (meth)acrylate groups, more preferably acrylate groups. It is further preferred that the compositions comprise at least one photoreactive component having a molecular weight of at least 500 g/mol, for instance at least 750 g/mol or at least 1250 g/mol. Generally, the weight average molecular weight will be below 30,000 g/mol. In certain embodiments it is also preferred that the photoreactive component comprises at least one aromatic ring, for instance at least two aromatic rings or at least 4 aromatic rings.

Preferred photoreactive components include (meth)acrylated epoxy components, *i.e.* components obtained by (meth)acrylating some or all of the epoxy groups present in an epoxy-functional component, for instance by (meth)acrylating epoxy groups present in one of the above-mentioned epoxy-functional components (*e.g.* epoxy novolacs and epoxy bisphenols). The (meth)acrylated epoxy component may be prepared by reacting an epoxy-functional component with an ethylenically unsaturated acid, for instance with an unsaturated monocarboxylic acid such as acrylic acid, methacrylic acid, crotonic acid, or cinnamic acid. Preferred acids include methacrylic acid and acrylic acid. Preferably, to obtain the (meth)acrylated epoxy component, at least 20 mol% of the epoxy groups in the epoxy-functional component are reacted with an ethylenically unsaturated acid, more preferably at least 60 mol%, and most preferably at least 90 mol%. In one embodiment, essentially all epoxy groups are reacted with an ethylenically unsaturated acid. In a further embodiment, the (meth)acrylated epoxy component is prepared by reacting 0.5-1.1 (e.g. 0.8-1.1) equivalents of unsaturated monocarboxylic acid with 1.0 equivalents of an epoxy component comprising at least two epoxy groups.

Especially preferred (meth)acrylated epoxy components include (meth)acrylated epoxy novolac components, such as acrylated phenol epoxy novolacs and acrylated cresol epoxy novolacs.

In certain embodiments, for instance in embodiments where the composition is desired to be aqueously developable (e.g. by aqueous alkaline solutions), it is preferred to acidify the (meth)acrylated epoxy component, for instance by reacting the (meth)acrylated epoxy component with a dicarboxylic acid or an anhydride. Preferred anhydrides include saturated or unsaturated polybasic acid anhydrides, e.g. dibasic acid anhydrides. Examples include maleic anhydride, succinic anhydride, itaconic anhydride, phthalic anhydride, tetrahydrophthalic anhydride, hexahydrophthalic anhydride, methylhexahydrophthalic anhdyride, endomethylenetetrahydrophthalic anhydride, methylendomethylenetetrahydrophthalic anhydride, chlorendic anhydride, and methyltetrahydrophthalic anhydride; aromatic polycarboxylic anhydrides such as trimellitic anhydride pyromellitic anhydride, and benzophenone-tetracarboxylic dianhydride; and polycarboxylic anhydride derivatives such as 5-(2,5-dioxotetrahydrofuryl)-3-methyl-3-cyclohexene-1,2-dicarboxylic anhydride; trimellitic acid anhydride and pyromellitic anhydride; and mixtures of the above-mentioned anhydrides. Especially preferred anhydrides include tetrahydrophtalic anhydride, phtalic anhydride, succinic anhydride, maleic anhydride, and mixtures thereof. Preferably, the acrylated epoxy component is reacted with 0.5-1.0 stoichiometric equivalents of anhydride, for instance 0.50-0.75 stoichiometric equivalents of anhydride.

Preferably, the present compositions comprise an acidified (meth)acrylated epoxy novolac having an acid number of preferably at least 50 mgKOH/g, more preferably at least 80 mgKOH/g, even more preferably at least 100 mgKOH/g, and most preferably at least 120 mgKOH/g. The present compositions preferably comprise an acidified (meth)acrylated epoxy novolac having an acid number of at most 200 mgKOH/g, more preferably at most 175 mgKOH/g, even more preferably at most 150 mgKOH/g, and most preferably at most 140 mgKOH/g.

### (b1) photoreactive component comprising a surfactant

It is preferred that the present compositions comprise at least one photoreactive component having at least one polyether surfactant grafted onto the component. Preferred photoreactive components comprising a polyether surfactant include those prepared by (meth)acrylating an epoxy-functional component comprising a polyether surfactant, more preferably by (meth)acrylating one of the epoxy-functional components described above under section (al). Preferred methods, ranges, and components for (meth)acrylating the epoxy-functional component comprising a polyether surfactant, as well as the optional acidification of the (meth)acrylated component, are similar to those described above under section (b).

### (c) photoinitiators

The compositions preferably comprise a photoinitiator system which generates free radicals in the presence of actinic radiation. Examples of chemical photoinitiator systems include benzophenone, benzoin ether, benzil ketals, acetophenone, phosphine oxide functional photoinitiators, and their derivatives. Other suitable initiator systems are described, for example, in U.S. Pat. Nos. 3,469,982, 4,451,523 and 4,358,477. Specific examples of photoinitiators include benzoin, benzoin methyl ether, benzoin ethyl ether, and benzoin isopropyl ether; acetophenone,2-2-dimethoxy-2-phenylacetophenone, 2,2-diethoxy-2-phenylacetophenone, 1,1-dichloroacetophenone, 1-hydroxycyclohexylphenylketone, and 2-methyl-1-(4-(methylthio)phenyl-2-morpholine-propan-1one; anthraquinones such as 2-methylanthraquinone, 2-ethylanthraquinone, 2-tertiary-butylanthraquinone, 1-chloroanthraquinone, and 2-amylanthraquinone; thioxanthones such as 2,4-dimethylthioxanthone, 2,4-diethylthioxanthone, 2-chlorothioxanthone, and 2,4-diisopropylthioxanthone; acetophenone dimethylketal and benzil dimethylketal; benzophenone and xanthones; acylphosphine oxide photoinitiators; 2,4,6-trimethyl benzoyldiphenyl phosphine oxide; and mixtures thereof. The present compositions preferably comprise at least one photoinitiator having a phosphine oxide moiety.

The present compositions preferably comprise, relative to the total weight of solids, from 0.1-20 wt% of one or more photoinitiators, more preferably 0.5-15 wt%, most preferably 6-12 wt%.

### (d) water

The present compositions comprise water. Preferably the present compositions comprise, relative to the total weight of the composition, at least 10 wt% of water, more preferably at least 20 wt%, most preferable at least 30 wt % of water. It is further preferred that the present compositions comprise, relative to the total weight of the composition, less than 80 wt% of water, more preferably less than 60 wt% of water, even more preferably less than 50 wt% of water, and most preferably less than 40 wt% of water.

In two part systems, it is preferred that each part comprises, relative to the total weight of both parts combined, at least 3 wt% of water. It is further preferred that at least one part comprises, relative to the total weight of both parts combined, at least 20 wt% of water.

In two part systems, not all the water for the coating composition needs to be already present in the two part system. For instance, water may be added upon or after mixing the two part system. Preferably at least 10 wt% of the water in the final coating composition, relative to the total weight of water in the final coating composition; is added during or after mixing the two part system, more preferably at least 25 wt%, most preferably at least 40 wt%.

### (e) polyether surfactants comprising one or more epoxy-reactive groups.

The present compositions may comprise a polyether surfactant comprising one or more epoxy-reactive groups, for instance one or more carboxylic acid groups. One of the benefits of the presence of epoxy-reactive groups is that the polyether surfactant, through reaction with one of the epoxy-functional components, can bind into the polymeric network that is formed upon cure. For instance, the epoxy-reactive polyether surfactants may bind in during a heat-curing step.

Suitable epoxy-reactive polyether surfactants are polymeric epoxy-reactive polyether surfactants. Preferred polyether surfactants include those that consist for at least 60 wt% of ether moieties, more preferably at least 80 wt%, and most preferably at least 95 wt%.

The epoxy-reactive polyethers may be homopolymers or copolymers. Preferred homopolymers include polyethylene oxide, polypropylene oxide, and polybutylene oxide. The epoxy-reactive polyethers copolymers may also be random copolymers or block copolymers. Preferred copolymers include poly(ethylene oxide-propylene oxide) and poly(ethylene oxide-polybutylene oxide) copolymers. Preferably the epoxy-reactive polyether copolymers are block copolymers.

Preferably the polyether surfactant comprises at least one terminus with isocyanate, hydroxyl, methoxy, and/or carboxylic acid functionality, more preferably at least one terminal carboxylic acid group or isocyanate group. The polyether may, for instance, be terminated at both ends of the polyether chain with a carboxylic acid group. Accordingly, suitable polyether surfactants include those represented by the following formula (I):

HOOC-(O-R¹)ₙ-(O-R²)ₘ-COOH (I)

wherein
R¹ and R² each represent a substituted or unsubstituted C₁-C₁₀, preferably C₂-C₄, alkyl group;
R¹ and R² do not represent the same group;
n represents an integer of 0-1000;
m represents an integer of 0-1000; and
n+m = at least 20, preferably at least 50, more preferably at least 100.

Also suitable are polyether surfactants having only one epoxy-reactive group, more preferably one terminal epoxy-reactive group, such as a terminal carboxylic acid or isocyanate group. Suitable polyethers comprising only one epoxy-reactive acid group may be obtained, for instance, by reacting a polyether diol with a carboxylic anhydride (for instance tetrahydrophtalic anhydride) or a polyisocyanate (e.g. isophorone diisocyanate or toluene diisocyanate). Examples of suitable commercial diols include, for instance, Pluronics F-88 (ethylene-oxide propylene oxide block copolymer commercially available from BASF, Mw = 11,000 g/mol).

The weight average molecular weight of the polyether surfactants (prior to grafting onto the epoxy-functional polymer) is preferably in the range of 500-50,000 g/mol, more preferably 1,000-20,000 g/mol, e.g. 1,000-15,000 g/mol or 5,000-20,000 g/mol.

The present compositions preferably comprise, relative to the total weight of solids, 0.1-15 wt% of epoxy-reactive polyether surfactant, more preferably 0.5-8 wt%, and most preferably 2-6 wt%.

### (f) additives

The present compositions may comprise any suitable additives. For instance, the compositions may comprise one or more suitable fillers, e.g., barium sulfate, silicon dioxide, talc, clay, calcium carbonate, silica, bentonite, kaolin, glass fiber, carbon fiber, or mica; one or more dyes or color pigments, e.g., phthalocyanine blue, phthalocyanine green, titanium dioxide, or carbon black; Also, the present compositions may comprise one or more antifoaming agents, flame-retardants, further surfactants, adhesiveness-imparting agents (e.g. mercaptosilanes), leveling agents, polymerization inhibitors (e.g. hydroquinone, hydroquinone monomethyl ether, pyrogallol, t-butyl catechol, or phenothiazine), photosensitizers, thixotropes, water thickeners, crosslinking agents and/or curing agents, minor amounts of organic solvent, etc.

Preferred water thickeners include polyvinyl alcohols. Polyvinyl alcohols may be substantially saponified poly-vinyl acetates, preferably being at least about 70% hydrolyzed, more preferably at least 80%, even more preferably at least 90%, and most preferably at least 93%. Preferably the present compositions comprise, relative to the total weight of solids, 0-10 wt% water thickeners, more preferably less than 5 wt%, even more preferably less than 3 wt%, and most preferably less than 1 wt%, for instance less than 0.5 wt%.

The compositions may comprise one or a mixture of two or more epoxy resin curing promoters and/or cross-linking agents. Examples include, for instance, blocked polyisocyanates, imidazole and imidazole derivatives such as 2-methylimidazole, 2-ethylimidazole, 2-ethyl-4-methylimidazole, 2-phenylimidazole, 4-phenylimidazole, 1-cyanoethyl-2-phenylimidazole, and 1-(2-cyanoethyl)-2-ethyl-4-methylimidazole; guanamines such as guanamine, acetoguanamine, and benzoguanamine; and amine compounds such as dicyandiamide, benzyldimethyl amine, 4-(dimethylamino)-N,N-dimethylbenzyl amine, 4-methoxy-N,N-dimethylbenzyl amine, 4-methyl-N,N-dimethylbenzyl amine, and melamine.

Preferred crosslinking/curing agents include imidazole and imidazole derivatives. An advantage of imidazoles is that they are generally soluble in water and, thus, less likely to coalesce with reactive solid particles that may be present in the compositions. This may, in particular in one-part systems, result in improved shelf life of the composition. Preferred thermal cross-linking agents also include aldehyde condensation products, such as, for instance, melamine-formaldehyde resins. Suitable melamine-formaldehyde resins are described in, for instance, U.S. Patents 5,536,620 and 4,247,621. Preferably, the melamine-formaldehyde resins are acrylated. It is further preferred that the melamine-formaldehyde resins are etherified.

In two part systems, it is preferred to provide epoxy curing and/or crosslinking agents, when used, in a different part than (non-acrylated) epoxy-functional components.

The compositions according to the present invention preferably comprise only comparatively small amounts of organic solvents and are, most preferably, even absent organic solvents. Accordingly, preferred compositions include those comprising, relative to the total weight of the composition, less than 10 wt% of organic solvents, more preferably less than 5 wt%, even more preferably less than 2 wt%, and most preferably about 0 wt% of organic solvent.

In two part systems, it is preferred that each part comprises, relative to the total weight of both parts combined, less than 5 wt% of organic solvents, more preferably less than 3 wt% of organic solvents. It is further preferred that at least one part comprises, relative to the total weight of both parts combined, less than 1 wt% of organic solvents.

Preferably the present compositions comprise, relative to the total weight of solids, 10-50 wt% of additives, more preferably 20-40 wt%. Preferably the present compositions comprise, relative to the total weight of solids, 10-40 wt% of fillers, more preferably 15-30 wt%.

### Dispersions and emulsions

Preferred compositions include emulsions and dispersions, with dispersions being particularly preferred. Accordingly, the present compositions may have the form of solid particles in a liquid phase. For instance, the compositions may comprise solid particles of epoxy-functional components and/or acrylated epoxy-functional components in water. Preferably, the average particle size of solid particles in the dispersions is 0.1-10 µm, more preferably 0.5-5 µm, and most preferably 0.5 - 1.0 µm.

### Applications

The present compositions are useful in the field of solder resists and etching resists for coating printed circuit board substrates.

The present compositions may be applied onto the printed circuit boards by any suitable process. Suitable processes include, for instance, screen coating, curtain coating, spray coating, roller coating, electrostatic spraying, dip coating, and spin coating.

After being applied to the substrate, the compositions are generally dried, e.g. by heat and/or vacuum, prior to exposure to actinic radiation in order to remove the water present in the composition. Preferably, the compositions are dried by heat at a temperature in the range of 60-100°C, for instance 75-90°C.

Suitable radiation for curing the compositions includes actinic radiation, e.g. ultraviolet (UV) radiation. It may be preferred, especially in the field of coating printed circuit boards, to only expose certain areas of the composition. Because only exposed areas will have undergone substantial polymerization and hardening, the unexposed areas can then be relatively easily separated (removed), e.g. by rinsing/washing the composition with a solvent, for instance an aqueous solvent such as an aqueous alkaline solution. After removal of the unexposed areas of the composition, the substrate will then comprise a pattern formed by exposed areas of the composition.

Furthermore, the compositions may be cured by heat Preferably, the compositions undergo a heat-curing step after having been exposed to actinic radiation (and after removal of any unexposed areas). Heat-curing may be effected by exposure of the composition to any suitable temperature, for instance by exposure to temperatures in the range of 100-300°C, e.g in the range of 125-200°C, 125-160 °C, or in the range of 135-150 °C.

### Examples

The following examples are given as particular embodiments of the invention and to demonstrate the practice and advantages thereof. It is to be understood that the examples are given by way of illustration and are not intended to limit the specification or the claims that follow in any manner.

### Glossary:

| **Ingredient** | **Description** |
|---|---|
| Acrylic acid | Acrylic acid, commercially available from Aldrich Chemical. |
| Aerosil 200 | Thixotrope; commercially available from Degussa-Huls. |
| Aerosil K-315 | Thixotrope; commercially available from Degussa-Huls. |
| Airvol 425 | Polyvinyl alcohol, 94-96% hydrolyzed; commercially available from Air Products and Chemicals. |
| AM-129 | Acrylated melamine resin; commercially available from Solutia. |
| Curezol 2MA-OK | Curing agent (2,4-&amino-6-{2'-methylimidazolyl-(1)']ethyl-s-triazine isocyanurate adduct); commercially available from Air Products and Chemicals. |
| DEN 439 | phenolic epoxy novolac resin (- 190 equivalent weight per epoxy, average epoxy groups/molecule ~3.8); commercially available from Dow Chemical. |
| DPS 164 | o-Cresol epoxy novolac resin (- 220 equivalent weight per epoxy, average epoxy groups/molecule ~5.0); commercially available from Resolution Performance Products. |
| Dyhard 100S | Dicyandiamide; Commercially available from SKS Chemicals. |
| EB 230 | Acrylated aliphatic urethane oligomer; Commercially available from UCB Chemicals. |
| EEP | 3-ethyl ethoxypropionate |
| Epirez 5003-W-55 | Solid bisphenol-A epoxy resin dispersed 55% solids in water; Commercially available from Resolution Performance Products. |
| Epirez 6006-W-70 | O-cresol novolac epoxy resin dispersed 70% solids in water; Commercially available from Resolution Performance Products. |
| Firstcure ITX | Photosensitizer; commercially available from First Chemicals. |
| Irgacure 819 | Photoinitiator; commercially available from Ciba Specialty Chemicals. |
| Irgacure 907 | Photoinitiator, commercially available from Ciba Specialty Chemicals. |
| Kathon LX-1.5% | Fungicide; commercially available from Rohm & Haas. |
| MEHQ | Methylhydroquinone, commercially available from Aldrich ChemicaL |
| Micral 932 | Filler/extender, commercially available from J.M. Huber. |
| Pluronics F-88 | Poly(oxyethylene-oxypropylene) block copolymer, Mw ~11,000 g/mol; commercially available from BASF. |
| PnP | Propylene glycol n-propyl ether |
| Rheolate 210 | Polyether urea polyurethane associative thickener; Commercially available from Rheox, Inc. |
| Rheolate 310 | Polyether polyol associative thickener; Commercially available from Rheox, Inc. |
| Rhodoline 6681 | Defoamer; Commercially available from Rhodia. |
| SB 520E35 | 35/65 solution of styrene-maleic anhydride copolymer in ethoxylated (3) trimethylolpropane triacrylate; commercially available from Sartomer. |
| Silysia 440 | Thixotrope, matting agent; commercially available from Fuji Silysia. |
| Sparmite F | Filler/extender; commercially available from Elementis Pigments. |
| SR 399 | Dipentaerythyl pentaacrylate; commercially available from Sartomer., |
| Sunsperse Green | GHD-9600 pigment dispersion; commercially available from Sun Chemicals. |
| Surfynol 104DPM | Flow agent; commercially available from Air Products and Chemicals. |
| Surfynol 420 | Flow agent; commercially available from Air Products and Chemicals. |
| Surfynol DF-75 | Defoamer; commercially available from Air Products and Chemicals. |
| Tego Dispers 735W | Filler dispersant; commercially available from Goldschmidt Chemicals. |
| Tego Dispers 740W | Filler dispersant; commercially available from Goldschmidt Chemicals. |
| THPA | Tetrahydrophthalic anhydride, commercially available from Aldrich Chemical. |
| TPP | Triphenylphosphine, commercially available from Aldrich Chemical. |
| Zircopax plus | Filler/extender; commercially available from Johnson Matthey. |

### Examples 1-9: Syntheses

### Example 1: Acidified Acrylated Epoxy Component

A photoactive, alkaline-soluble o-cresol epoxy novolac oligomer was produced by dissolving 900.0 g. DPS-164 and 1.0 g. MEHQ in 482.2 g. of toluene in a 3-1 glass reaction flask under agitation at 80°C. 275.7 g. of acrylic acid and 6.1 g. of TPP were added. The reaction was allowed to run for 6 hours at 117°C under reflux. Acid number was reduced from 190.6 mg. KOH/g. to 1.5 meq. KOH/g., indicating a 99% reaction completion. The temperature was reduced to 90°C, and an additional 263.0 g. of toluene was added. 287.2 g. of THPA was added to the flask, and the acidification reaction was allowed to proceed for 3 hours at 90°C until a final acid number of 128.3 meq. KOH/g was achieved. The reaction yielded 2212.7 g. of a 70%-solids solution of a photoactive, alkaline-soluble o-cresol epoxy novolac.

| Ingredient | Weight |
|---|---|
| DPS-164 | 900.0 g. |
| MEHQ | 1.0 g. |
| toluene | 515.2 g. |
| acrylic acid | 294.5 g. |
| TPP | 6.7 g. |
| toluene | 263.0 g. |
| THPA | 613.6 g. |

### Example 2: Acidified Acrylated Epoxy Component

In a likewise manner as in Example 1, a photoactive, alkaline-soluble o-cresol epoxy novolac oligomer was produced by dissolving 842.4 g. DPS-164 and 1.0 g. MEHQ in 482.2 g. of toluene in a 3-1 glass reaction flask under agitation at 80°C. 275.7 g. of acrylic acid and 6.1 g. of TPP were added. The reaction was allowed to run for 6 hours at 117°C under reflux. Acid number was reduced from 190.6 mg. KOH/g. to 1.5 meq. KOH/g., indicating a 99% reaction completion. The temperature was reduced to 90°C, and an additional 410.3 g. of toluene was added. 287.2 g. of THPA was added to the flask, and the acidification reaction was allowed to proceed for 3 hours at 90°C until a final acid number of 75.0 meq. KOH/g was achieved. The reaction yielded 1940.0 g. of a 70%-solids solution of a photoactive, alkaline-soluble o-cresol epoxy novolac.

| Ingredient | Weight |
|---|---|
| DPS-164 | 842.4 g. |
| MEHQ | 1.0 g. |
| toluene | 482.2 g. |
| acrylic acid | 275.7 g. |
| TPP | 6.1 g. |
| toluene | 123.0 g. |
| THPA | 287.2 g. |

### Example 3: Reactive Surfactant

A reactive group was added onto an ethylene oxide-propylene oxide block co-polymer surfactant by reacting 1200 grams of Pluronics F-88 (2 hydroxyl equivalents; MW=11,000) and 16.6 grams of THPA (2 equivalent) for 2 hours at 100°C in a 3-liter glass reaction kettle. The final acid number was 10.3.

| Ingredient | Weight |
|---|---|
| EO/PO block copolymer (Pluronic F-88) | 1200.0 g. |
| THPA | 33.2 g. |

### Example 4: Epoxy Component with Surfactant Grafted onto its Backbone

A surfactant-grafted epoxy phenolic novolac oligomer was produced by reacting 1200 grams of Pluronic F-88 (2 hydroxyl equivalents; MW=11,000) and 16.6 grams of THPA (1 equivalent; MW=152) for 2 hours at 100°C in a 3-liter glass reaction kettle (acid number=5.6). To this product 80.7 grams of DEN 439 was added and held at 120°C for 2 hours. The acid number reduced from 5.6 to 0.4 over the course of the reaction.

| Ingredient | Weight |
|---|---|
| EO/PO block copolymer (Pluronic F-88) | 1200 g. |
| THPA | 16.6 g. |
| DEN 439 | 80.7 g. |

### Example 5: Epoxy Component with Surfactant Grafted onto its Backbone

A surfactant-grafted epoxy cresol novolac oligomer was produced by reacting 1200 grams of Pluronic F-88 (2 hydroxyl equivalents; MW=11,000) and 16.6 grams of THPA (1 equivalent) for 2 hours at 100°C in a 3-liter glass reaction kettle (acid number=5.1). To this product 120.2 grams of DPS-164 was added and held at 100°C for 3 hours. The acid number reduced from 5.1 to 0.2 over the course of the reaction.

| Ingredient | Weight |
|---|---|
| EO/PO block copolymer (Pluronic F-88) | 1200 g. |
| THPA | 16.6 g. |
| DPS-164 | 120.0 g. |

### Example 6: Epoxy Component with Surfactant Grafted onto its Backbone

A surfactant-grafted epoxy phenolic novolac/epoxy cresol novolac oligomer blend was produced by first reacting 350.0 grams ofPluronic F-88, with 11.0 grams of 2,4-toluene diisocyanate (2,4-TDI) at 90°C for 1 hours in a 2-liter glass reaction kettle. 146 grams of the resulting molten waxy material was then blended with DPS 164 and DEN 439 and held at 88°C for 1/2 hour. FTIR analysis of the resulting surfactant-grafted epoxy phenolic novolac/epoxy cresol novolac oligomer blend indicated the presence of urethane groups. Molecular weight determination via GPC indicated a weight average molecular weight (Mw) of 22823 g/mol and a number average molecular weight (Mn) of 1218 g/mol.

| Ingredient | Weight |
|---|---|
| EO/PO block copolymer (Pluronic F-88) | 143.7 g. |
| TDI | 2.3 g. |
| DEN 439 | 751.0 g. |
| DPS-164 | 248.0 g. |

### Example 7: Epoxy Component with Surfactant Grafted onto its Backbone

In a likewise manner to example 6, a surfactant-grafted epoxy cresol novolac oligomer was produced by reacting 871.6 grams of DPS-164,126.3 grams of Pluronics F-88, and 2.1 grams of toluene diisocyanate (TDI) at 90°C for 1.5 hours in a 2-liter glass reaction kettle.

| Ingredient | Weight |
|---|---|
| EO/PO block copolymer (Pluronic F-88) | 126.3 g. |
| TDI | 2.1 g. |
| DPS-164 | 871.6 g. |

### Example 8: Acidified Acrylated Epoxy Component with Surfactant Grafted onto Backbone

4000g of DPS-164, 592g of DPS-164 grafted with Pluronic F-88 (from Example 5), and 5g MEHQ were dissolved in 2536g of toluene in a 5 gallon reaction kettle under agitation at 80°C. 1298 grams of acrylic acid and 22 grams of triphenylphosphine were added to the kettle, and the acrylation reaction was run for 6 hours at 117°C under reflux. The acid number reduced to 2.2 over the 6-hour process. The acrylated, surfactant-grafted epoxy cresol novolac oligomer in an additional 587 grams of toluene was further reacted with 1371 grams of THPA for 3 hours at 90°C to an acid number of 78.3.

| Ingredient | Weight |
|---|---|
| DPS-164 | 4000.0g. |
| Epoxy with grafted surfactant (Example 5) | 592.0 g. |
| MEHQ | 5.0 g. |
| toluene | 2536.0 g. |
| acrylic acid | 1298.0g. |
| TPP | 22.0 g. |
| toluene | 587.0 g. |
| THPA | 1371.0 g |

### Example 9: Acidified Acrylated Epoxy Component with Surfactant Grafted onto Backbone

550.0 grams of DPS-164, 81.0 g of DPS-164 grafted with Pluronic F-88 (Example 6), and 0.7 g MEHQ were dissolved in 314.4 grams of toluene in a 3-liter reaction flask under agitation at 80°C. 174.5 grams of acrylic acid and 4.1 grams of triphenylphosphine were added to the flask, and the acrylation reaction was run for 6 hours at 117°C under reflux. The acid number reduced from 190.6 to 1.5. The acrylated, surfactant-grafted epoxy cresol novolac oligomer in an additional 151.3 grams of toluene was further reacted with 350.2 grams of THPA for 3 hours at 100°C. The final acid number was 128.3.

| Ingredient | Weight |
|---|---|
| DPS-164 | 550.0 g. |
| Epoxy grafted surfactant (Example 6) | 81.0 g. |
| MEHQ | 0.7 g. |
| toluene | 314.4 g. |
| acrylic acid | 180.0 g. |
| TPP | 4.1 g. |
| toluene | 151.3 g. |
| THPA | 350.2 g. |

### Examples 10-14: Dispersions

### Example 10

432.5 grams of toluene from 1441.7 grams of the self-emulsifiable acidified o-cresol epoxy novolac acrylate oligomer/toluene mixture produced in Example 8 was removed using vacuum distillation. The resulting 1009.2 grams of solid product was blended with 69.6 grams of PnP, 50.4 grams of Modaflow resin, 151.2 grams of Santolink AM-129, 50.4 grams of Sarbox SB 520E35, 75.6 grams of SR 399, 2.0 grams Surfynol DF-75, 201.6 grams of Irgacure 907, and 50.4 grams of Firstcure ITX for 1 hour at 90°C under agitation in a 3-1 glass reaction vessel. The resulting mixture was dispersed in water using a phase inversion process in which 297.0 grams of a 10% aq. Airvol 425 solution and 121.8 grams of deionized water were slowly added to the mixture at 100 rpm. The temperature was slowly reduced to 48°C at which point the mixture inverted to a water-continuous dispersion. The resulting dispersion was mixed for an additional 17 hours to obtain a mean particle size of 1.35 microns as measured on a Coulter LS Particle Size Analyzer. The temperature of the dispersion was slowly reduced to a final temperature of 32°C over the course of the additional 17 hours, yielding 2669.5 grams of a water-continuous, stable photoactive and alkaline soluble dispersion.

| Ingredient | Weight (g) | Weight (%) |
|---|---|---|
| Acidified Epoxy Acrylate Oligomer with | 1009.2 | 37.8 |
| Grafted Surfactant (Example 8) | | |
| PnP | 69.6 | 2.6 |
| Modaflow resin | 50.4 | 1.9 |
| AM-129 | 151.2 | 5.7 |
| SB 520E35 | 50.4 | 1.9 |
| SR 399 | 75.6 | 2.8 |
| Surfynol DF-75 | 2.0 | 0.07 |
| Irgacure 907 | 201.6 | 7.6 |
| Firstcure ITX | 50.4 | 1.9 |
| 10 % Airvol 425 solution | 297.0 | 11.1 |
| DI water | 712.3 | 26.7 |

### Example 11

445.9 grams of toluene from 1486.4 grams of the self emulsifiable acidified o-cresol epoxy novolac acrylate oligomer/toluene mixture produced in Example 9 was removed using vacuum distillation. The resulting 1040.5 grams of solid product was blended with 78.1 grams of PnP, 30.7 grams of Modaflow resin, 121.0 grams of Santolink AM-129, 48.9 grams of Sarbox SB 520E35, 2.0 grams Surfynol DF-75, 169.9 grams of Irgacure 907, 21.1 grams of Irgacure 819 and 41.8 grams of Firstcure ITX for 1 hour at 90°C under agitation in a 3-1 glass reaction vessel. The resulting mixture was dispersed in water using a phase inversion process in which 267.2 grams of a 10% aq. Airvol 425 solution and 121.8 grams of deionized water were slowly added to the mixture at 100 rpm. In a likewise manner as in Example 10, the mixture inverted to a water-continuous dispersion yielding 2451.0 grams of a water-continuous, stable photoactive and alkaline soluble dispersion with a mean particle size of 1.2 microns as measured on a Coulter LS Particle Size Analyzer.

| Ingredient | Weight (g) | Weight (%) |
|---|---|---|
| Acidified Epoxy Acrylate Oligomer with | 1040.5 | 42.5 |
| Grafted Surfactant (Example 9) | | |
| PnP | 78.1 | 3.2 |
| Modaflow resin | 30.7 | 1.3 |
| AM-129 | 121.0 | 4.9 |
| SB 520E35 | 48.9 | 2 |
| Surfynol DF-75 | 2.0 | 0.08 |
| Irgacure 907 | 169.9 | 6.9 |
| Irgacure 819 | 21.1 | 0.9 |
| Firstcure ITX | 41.8 | 1.7 |
| 10 % Airvol 425 solution | 267.2 | 10.9 |
| DI water | 625.0 | 25.5 |

### Example 12:

424.7 grams of toluene from 1415.5 grams of the acidified o-cresol epoxy novolac acrylate oligomer/toluene mixture produced in Example 1 was removed using vacuum distillation. The resulting 990.9 grams of solid product was blended with 74.8 grams of the carboxyl terminated EO/PO block copolymer produced in Example 3, 74.4 grams of PnP, 23.7 grams of Modaflow resin, 124.5 grams of Santolink AM-129, 49.9 grams of Sarbox SB 520E35, 1.0 grams Surfynol DF-75, 174.4 grams of Irgacure 907, 24.7 grams of Irgacure 819 and 42.8 grams of Firstcure ITX for 1 hour at 90°C under agitation in a 3-1 glass reaction vessel. The resulting mixture was dispersed in water using a phase inversion process in which 267.2 grams of a 10% aq. Airvol 425 solution and 121.8 grams of deionized water were slowly added to the mixture at 100 rpm. In a likewise manner as to Example 10, the mixture inverted to a water-continuous dispersion yielding 2471.1 grams of a water-continuous, stable photoactive and alkaline soluble dispersion with a mean particle size of 1.3 microns as measured on a Coulter LS Particle Size Analyzer.

| Ingredient | Weight (g) | Weight (%) |
|---|---|---|
| Acidified Epoxy Acrylate Oligomer | 990.9 | 40.1 |
| (Example 1) | | |
| Carboxyl terminated EO/PO block | 74.8 | 3 |
| copolymer (Example 3) | | |
| PnP | 74.4 | 3 |
| Modaflow | 23.7 | 1 |
| AM-129 | 124.5 | 5 |
| SB 520E35 | 49.9 | 2 |
| Surfynol DF-75 | 1.0 | 0.04 |
| Irgacure 907 | 174.4 | 7.1 |
| Irgacure 819 | 24.7 | 1 |
| Firstcure ITX | 42.8 | 1.7 |
| 10 % Airvol 425 solution | 254.5 | 10.3 |
| DI water | 635.5 | 25.7 |

### Example 13:

494.0 grams of toluene from 1646.6 grams of the acidified o-cresol epoxy novolac acrylate oligomer/toluene mixture produced in Example 1 was removed using vacuum distillation. The resulting 1152.6 grams of solid product was blended with 34.2 grams of the carboxyl terminated EO/PO block copolymer produced in Example 3, 40.8 grams of butyl carbitol, 47.9 grams of EEP, 336.2 grams of a 21% aq. Airvol 205 solution, 153.7 grams of Irgacure 907, 51.4 grams of Irgacure 1700 and 17.1 grams of Firstcure ITX for 1 hour at 90°C under agitation in a 3-1 glass reaction vessel. The resulting mixture was dispersed in water using a phase inversion process in which 550.9 grams of deionized water was slowly added to the mixture at 100 rpm. In a likewise manner as to Example 10, the mixture inverted to a water-continuous dispersion yielding 2451.0 grams of a water-continuous, stable photoactive and alkaline soluble dispersion with a mean particle size of 2.0 microns as measured on a Coulter LS Particle Size Analyzer.

| Ingredient | Weight (g) | Weight (%) |
|---|---|---|
| Acidified Epoxy Acrylate Oligomer | 1152.6 | 48.3 |
| (Example 1) | | |
| Carboxyl terminated EO/PO block | 34.2 | 1.4 |
| copolymer (Example 3) | | |
| Butyl carbitol | 40.8 | 1.7 |
| EEP | 47.9 | 2 |
| Airvol 205 solution (21%) | 336.2 | 14.1 |
| Irgacure 907 | 153.7 | 6.4 |
| Irgacure 1700 | 51.4 | 2.1 |
| Firstcure ITX | 17.1 | 0.7 |
| DI water | 550.8 | 23.1 |

### Example 14:

500.9 grams of toluene from 1669.5 grams of the acidified o-cresol epoxy novolac acrylate oligomer/toluene mixture produced in Example 1 was removed using vacuum distillation. The resulting 1168.6 grams of solid product was blended with 93.4 grams ofPnP, 87.6 grams of Pluronics F-88, 145.9 grams of Santolink AM-129, 43.8 grams of Sarbox SB 520E35, 2.5 grams Surfynol DF-75, 203.2 grams of Irgacure 907, 29.2 grams of Irgacure 819 and 50.2 grams of Firstcure ITX for 1 hour at 90°C under agitation in a 3-1 glass reaction vessel. The resulting mixture was dispersed in water using a phase inversion process in which 321.4 grams of a 10% aq. Airvol 425 solution and 510.8 grams of deionized water were slowly added to the mixture at 100 rpm. In a likewise manner as to Example 10, the mixture inverted to a water-continuous dispersion yielding 2003.1 grams of a water-continuous, stable photoactive and alkaline soluble dispersion with a mean particle size of 1.3 microns as measured on a Coulter LS Particle Size Analyzer.

| Ingredient | Weight (g) | Weight (%) |
|---|---|---|
| Acidified Epoxy Acrylate Oligomer | 1168.7 | 44 |
| (Example 1) | | |
| PnP | 93.4 | 3.5 |
| Pluronics F-88 | 87.6 | 3.3 |
| AM-129 | 145.9 | 5.5 |
| SB 520E35 | 43.8 | 1.7 |
| Surfynol DF-75 | 2.5 | 0.1 |
| Irgacure 907 | 203.2 | 7.7 |
| Irgacure 819 | 29.2 | 1.1 |
| Firstcure ITX | 50.2 | 1.9 |
| 10 % Airvol 425 solution | 321.4 | 12.2 |
| DI water | 510.8 | 19 |

### Examples 15-17: Filler Slurries

### Example 15:

A 1.2 liter stainless steel mixing vessel was charged with 110.5 grams of GHD-9006 Sunsperse Green, 289.5 grams of deionized water, 17.1 grams Tego Dispers 740W, 13.2 grams Tego Dispers 735W, 3.9 grams of Surfynol 420 (Air Products), and mixed at 600 rpm under a high-shear mixer with a Hockmeyer G-style mixing blade until homogeneous. 88.2 grams of Silysia 440, 350.0 grams Micral 932, 350.0 grams Zircopax Plus and 350.0 grams of Sparmite F were added slowly under mixing until completely dispersed. Mixing speed was increased to 1300 rpm as the materials were introduced to insure continuous dispersion.
Once the fillers were added, the mixture was allowed to mix for 20 minutes to insure dispersion. 9.2 grams of Curezol 2MA-OK and 9.2 grams Surfynol DF-75 were slowly added, and the mixture allowed to mix at 1300 rpm for 15 minutes until homogeneous. 131.6 grams of a 15% aq. Airvol 425 solution was added, and the final mixture was stirred at 600 rpm for 15 minutes to insure complete homogeneity. The resulting slurry was filtered through a 75 µm filter media, yielding 1470.9 grams of filtered slurry.

| Ingredient | Weight (g) | Weight (%) |
|---|---|---|
| Sunsperse Green | 110.5 | 6.4 |
| DI water | 289.5 | 16.8 |
| Dispers 740W | 17.1 | 1.0 |
| Dispers 735W | 13.2 | 0.8 |
| Surfynol 420 | 3.9 | 0.2 |
| Silysia 440 | 88.2 | 5.1 |
| Micral 932 | 350.0 | 20.3 |
| Zircopax Plus | 350.0 | 20.3 |
| Sparmite F | 350.0 | 20.3 |
| 2MA-OK | 9.2 | 5.3 |
| Surfynol DF-75 | 9.2 | 5.3 |
| 15% Airvol 425 solution | 131.6 | 7.6 |

### Example 16:

A 1.2 liter stainless steel mixing vessel was charged with 113.8 grams of GHD-9006 Sunsperse Green, 221.4 grams of deionized water, 17.3 grams Tego Dispers 740W, 7.4 grams Tego Dispers 735W, 3.7 grams of Surfynol 420 (Air Products), and mixed at 600 rpm under a high-shear mixer with a Hockmeyer G-style mixing blade until homogeneous. 22.3 grams of Aerosil 200, 350.0 grams Micral 932, 350.0 grams Zircopax Plus and 350.0 grams of Sparmite F were added slowly under mixing until completely dispersed. Mixing speed was increased to 1300 rpm as the materials were introduced to insure continuous dispersion.
Once the fillers were added, the mixture was allowed to mix for 20 minutes to insure dispersion. 13.6 grams of Curezol 2MA-OK and 5.0 grams Surfynol DF-75 were slowly added, and the mixture allowed to mix at 1300 rpm for 15 minutes until homogeneous. 288.2 grams of a 15% aq. Airvol 425 solution was added, and the final mixture was stirred at 600 rpm for 15 minutes to insure complete homogeneity. The resulting slurry was filtered through a 75 µm filter media, yielding 1416.8 grams of filtered slurry.

| Ingredient | Weight (g) | Weight (%) |
|---|---|---|
| Sunsperse Green | 113.8 | 6.5 |
| DI water | 221.4 | 12.7 |
| Dispers 740W | 17.3 | 1.0 |
| Dispers 735W | 7.4 | 0.4 |
| Surfynol 420 | 3.7 | 0.2 |
| Aerosil 200 | 22.3 | 1.3 |
| Micral 932 | 350.0 | 20.1 |
| Zircopax Plus | 350.0 | 20.1 |
| Sparmite F | 350.0 | 20.1 |
| 2MA-OK | 13.6 | 0.8 |
| Surfynol DF-75 | 5.0 | 0.3 |
| 15% Airvol 425 solution | 288.2 | 16.5 |

### Example 17:

A 1.2 liter stainless steel mixing vessel was charged with 113.3 grams of GHD-9006 Sunsperse Green, 221.6 grams of deionized water, 17.6 grams Tego Dispers 740W, 7.6 grams Tego Dispers 735W, 3.8 grams of Surfynol 420 (Air Products), and mixed at 600 rpm under a high-shear mixer with a Hockmeyer G-style mixing blade until homogeneous. 22.7 grams of Aerosil 200, 350.0 grams Micral 932, 350.0 grams Zircopax Plus and 350.0 grams of Sparmite F were added slowly under mixing until completely dispersed. Mixing speed was increased to 1300 rpm as the materials were introduced to insure continuous dispersion.
Once the fillers were added, the mixture was allowed to mix for 20 minutes to insure dispersion. 13.8 grams of Curezol 2MA-OK and 5.0 grams Surfynol DF-75 were slowly added, and the mixture allowed to mix at 1300 rpm for 15 minutes until homogeneous. 287.1 grams of a 15% aq. Airvol 425 solution was added, and the final mixture was stirred at 600 rpm for 15 minutes to insure complete homogeneity. The resulting slurry was filtered through a 75 µm filter media, yielding 1430.5 grams of filtered slurry.

| Ingredient | Weight (g) | Weight (%) |
|---|---|---|
| Sunsperse Green | 113.3 | 6.5 |
| DI water | 221.6 | 12.7 |
| Dispers 740W | 17.6 | 1 |
| Dispers 735W | 7.6 | 0.4 |
| Surfynol 420 | 3.8 | 0.2 |
| Aerosil 200 | 22.7 | 1.3 |
| Micral 932 | 350.0 | 20.1 |
| Zircopax Plus | 350.0 | 20.1 |
| Sparmite F | 350.0 | 20.1 |
| 2MA-OK | 13.8 | 0.8 |
| Surfynol DF-75 | 5.0 | 0.3 |
| 15% Airvol 425 solution | 287.1 | 16.5 |

### Example 18: Aerosil Dispersion

A mixing vessel was charged with 92.1 grams of deionized water, 0.2 grams Tego Dispers 740W, 0.5 grams Tego Dispers 735W, and 0.3 grams of Rhodoline 6681. 12.4 grams of Aerosil 200 were added while mixing at 600 rpm under a high-shear mixer with a Hockmeyer G-style mixing blade until homogeneous. 0.2 grams of Rheolate 210 was added, and the final mixture was stirred at 600 rpm for 15 minutes to insure complete homogeneity. The resulting dispersion was filtered through a 75-µm filter media.

| Ingredient | Weight (g) | Weight (%) |
|---|---|---|
| DI water | 92.1 | 87.1 |
| Tego Disperse 740W | 0.2 | 0.2 |
| Tego Disperse 735W | 0.5 | 0.5 |
| Rhodoline 6681 | 0.3 | 0.3 |
| Aerosil 200 | 12.4 | 11.7 |
| Rheolate 210 | 0.2 | 0.2 |

### Example 19: Monomer Slurry

A stainless steel mixing vessel was charged with 18.7 grams of DI water, 10.9 grams of GHD-9006 Sunsperse Green, deionized water, 3.2 grams Tego Dispers 740W, and 2.6 grams of Rhodoline 6681 under mixing at 600 rpm with a high-shear mixer with a Hockmeyer G-style mixing blade. To the vessel, 2.9 grams of Dyhard 100S, 24.8 grams Micral 932, 24.8 grams Zircopax Plus and 24.8 grams of Sparmite F were then added slowly under mixing at 1300 rpm for 20 minutes. 0.6 grams of Rheolate 310, 26.8 grams of AM 129,4.0 grams of SR 399, and 11.9 grams of EB 230 were then slowly added to the vessel, and the resulting mixture was allowed to mix at 1300 rpm for 15 minutes until homogeneous. 40.8 grams of a 21% aqueous Airvol 205 solution was added, and the final mixture was stirred at 600 rpm for 15 minutes to insure homogeneity.
The resulting slurry was filtered through a 75-µm filter media, yielding 1430.5 grams of filtered slurry

| Ingredient | Weight (g) | Weight (%) |
|---|---|---|
| DI water | 18.7 | 9.5 |
| Tego Disperse 740W | 3.2 | 1.6 |
| Rhodoline 6681 | 2.6 | 1.3 |
| Dyhard 100S | 2.9 | 1.5 |
| Sparmite F | 24.8 | 12.6 |
| Zircopax | 24.8 | 12.6 |
| Micral 932 | 24.8 | 12.6 |
| Sunsperse Green | 10.9 | 5.5 |
| Rheolate 310 | 0.6 | 0.3 |
| AM 129 | 26.8 | 13.6 |
| SR 399 | 4 | 2 |
| EB 230 | 11.9 | 6 |
| Airvol 205 solution (21%) | 40.8 | 20.7 |

### Example 20: Filler Slurry

A mixing vessel was charged with 1.08 1bs. of GHD-9006 Sunsperse Green, 2.12 lbs. of deionized water, 0.15 lbs. Tego Dispers 740W, 0.05 lbs. Tego Dispers 735W, 0.261bs. of Surfynol 104DPM (Air Products), and mixed at 600 rpm under a high-shear mixer with a Hockmeyer G-style mixing blade until homogeneous. 0.20 lbs. of Aerosil 200, 3.38 1bs. Micral 932, 3.38 lbs. Zircopax Plus and 3.38 lbs. of Sparmite F were added slowly to the vessel under mixing until completely dispersed. Mixing speed was increased to 1300 rpm as the materials were introduced to insure continuous dispersion. Once these fillers were added, the mixture was allowed to mix for 20 minutes to insure dispersion. 0.12 lbs. of Curezol 2MA-OK and 0.31 1bs Surfynol DF-75 were then slowly added to the vessel, and the mixture was allowed to mix at 1300 rpm for 15 minutes until homogeneous. 3.01 lbs. of a 15% aqueous Airvol 425 solution was added, and the final mixture was stirred at 600 rpm for 15 minutes to insure homogeneity.
The resulting slurry was filtered through a 75-µm filter media, yielding 1430.5 grams of filtered slurry

| Ingredient | Weight (g) | Weight (%) |
|---|---|---|
| Sunsperse Green | 1.08 | 6.2 |
| DI water | 2.12 | 12.2 |
| Dispers 740W | 0.15 | 0.9 |
| Dispers 735W | 0.05 | 0.3 |
| Surfynol 104DPM | 0.26 | 1.5 |
| Aerosil 200 | 0.20 | 1.1 |
| Micral 932 | 3.38 | 19.4 |
| Zircopax Plus | 3.38 | 19.4 |
| Sparmite F | 3.38 | 19.4 |
| 2MA-OK | 0.12 | 0.7 |
| Surfynol DF-75 | 0.31 | 1.8 |
| 15% Airvol 425 solution | 3.01 | 17.3 |

### Example 21: Epoxy Dispersion

A 3-liter glass reaction kettle was loaded with 900 grams of DEN 439, 300 grams of DPS 164, 90 grams of an epoxy-grafted surfactant (Example 4), 24.0 grams of Modaflow, 8.0 grams of Surfynol DF-75, and 41.3 grams of PnP. The materials were heated to 90°C while mixing at 60 rpm, and held for 1-hour. Heating of the kettle was stopped and 262 grams of DI water was dripped in over 30 minutes while the kettle cooled down. At the completion of the DI water addition, 159.0 grams of 10%-aqueous Airvol 425 solution was dripped in over 15 minutes. The mixture naturally cooled to 50°C were it inverted to a water-continuous dispersion. Following 12-hours of mixing, a mono-modal particle distribution was obtained having a mean particle size of 1.523 µm. The dispersion was further let down with 270.0 grams of DI water and 1.8 grams of Kathon LX solution (1.5%).
The resulting dispersion had a viscosity at 10 rpm of 24,600 cps and a viscosity at 1 rpm of 78,000 cps as determined with a Brookfield RVT viscometer , #6 spindle at 25°C.

| Ingredient | Weight (g) | Weight (%) |
|---|---|---|
| DEN 439 | 45.4 | 43.9 |
| Epoxy grafted surfactant (Example 3) | 4.5 | 4.3 |
| Modaflow | 1.2 | 1.2 |
| PnP | 2.1 | 2.0 |
| Airvol 425 | 0.8 | 0.8 |
| DI water | 33.9 | 32.8 |
| Kathon LX-1.5% | 0.1 | 0.1 |
| DPS-164 | 15.1 | 14.6 |
| Surfynol DF-75 | 0.4 | 0.4 |

### Example 22: Epoxy Dispersion

A 3-liter glass reaction kettle was loaded with 751 grams of DEN 439, 248 grams of DPS 164, 145.9 grams of an epoxy-grafted surfactant (Example 6), and 42.0 grams of PnP. The materials were heated to 90°C while mixing at 60 rpm, and held for 1-hour. Heating of the kettle was stopped and 233.9 grams of DI water was dripped in over 30 minutes while the kettle cooled down. At the completion of the DI water addition, 111.0 grams of 10%-aqueous Airvol 425 solution was dripped in over 15 minutes. The mixture naturally cooled to 50°C were it inverted to a water-continuous dispersion. Following 12-hours of mixing a mean particle size of 0.787 µm was obtained. The dispersion was further let down with 348 grams of DI water and 1.8 grams of Kathon LX solution (1.5%).

| Ingredient | Weight (g) | Weight (%) |
|---|---|---|
| DEN 439 | 50.8 | 39.1 |
| DPS-164 | 16.8 | 12.9 |
| Epoxy grafted surfactant (Example 5) | 9.9 | 7.6 |
| PnP | 2.8 | 2.2 |
| Airvol 425 | 0.8 | 0.6 |
| DI water | 48.8 | 37.5 |
| Kathon LX-1.5% | 0.1 | 0.1 |

### Example 23: Epoxy Dispersion

A 3-liter glass reaction kettle was loaded with 900 grams of DEN 439, 300 grams of DPS 164, 90 grams of an carboxyl terminated EO/PO block copolymer (example 2), 7.1 grams of Surfynol DF-75 and 40.9 grams of PnP. The materials were heated to 90°C while mixing at 60 rpm, and held for 1-hour. Heating of the kettle was stopped and 262 grams of DI water was dripped in over 30 minutes while the kettle cooled down. At the completion of the DI water addition, 166.0 grams of 10%-aqueous Airvol 425 solution was dripped in over 15 minutes. The mixture naturally cooled to 50°C were it inverted to a water-continuous dispersion. Following 12-hours of mixing a mono-modal particle distribution was obtained having a mean particle size of 0.976 µm. The dispersion was further let down with 304.0 grams of DI water and 1.8 grams of Kathon LX solution (1.5%).
The dispersion had a viscosity at 10 rpm of 66,300 cps and a viscosity at 1 rpm of 300,000 cps as determined with a Brookfield RVT viscometer, #6 spindle at 25°C.

| Ingredient | Weight (g) | Weight (%) |
|---|---|---|
| DEN 439 | 50.6 | 43.4 |
| Carboxyl terminated EO/PO block | 5.1 | 4.4 |
| copolymer (Example 2) | | |
| PnP | 2.3 | 2.0 |
| Airvol 425 | 0.9 | 0.8 |
| DI water | 40.2 | 34.5 |
| Kathon LX-1.5% | 0.1 | 0.1 |
| DPS-164 | 16.9 | 14.5 |
| Surfynol DF-75 | 0.4 | 0.3 |

### Examples 24-28: Printed Circuit Board Coating Compositions

### Example 24:

In a one-gallon mixing vessel, 1391.9 grams of oligomer dispersion (Example 10) was loaded. Under high-shear mixing at 600 rpm using a Cowles type disperser, 423.1 grams of filler slurry (Example 15), 60.5 grams of Silysia 440, and 124.5 grams ofDI water were added to the vessel. The resulting mixture was stirred at 600 rpm for 30 minutes to insure homogeneity and filtered through a 75-µm filter media. The filtered mixture was hand mixed with 313.3 grams of epoxy dispersion (Example 21) and letdown with 593.7 grams of DI water.

| Ingredient | Weight (%) |
|---|---|
| Oligomer Dispersion (Ex. 10) | 52.80 |
| Filler Slurry (Ex. 15) | 13.15 |
| Thixotrope: Silysia 440 | 1.40 |
| DI water | 5.20 |
| Epoxy Dispersion (Ex. 21) | 10.45 |
| Letdown DI water | 17.00 |

### Example 25:

In a one-gallon mixing vessel, 1411.4 grams of oligomer dispersion (Example 11) was loaded. Under high-shear mixing at 600 rpm using a Cowles type disperser, 406.8 grams of filler slurry (Example 15), 59.0 grams of Silysia 440, and 122.8 grams of DI water were added to the vessel. The resulting mixture was stirred at 600 rpm for 30 minutes to insure homogeneity and filtered through a 75-µm filter media.
The filtered mixture was hand mixed with 374.9 grams of epoxy dispersion (Example 22) and letdown with 631.8 grams of DI water.

| Ingredient | Weight (%) |
|---|---|
| Oligomer Dispersion | 41.85 |
| Filler Slurry | 26.30 |
| Thixotrope: Silysia 440 | 1.75 |
| DI water | 3.65 |
| Epoxy Dispersion | 11.20 |
| Letdown DI water | 15.25 |

### Example 26:

In a one-gallon mixing vessel, 1414.8 grams of oligomer dispersion (Example 12) was loaded. Under high-shear mixing at 600 rpm using a Cowles type disperser, 420.5 grams of filler slurry (Example 16), 62.9 grams of Silysia 440, and 101.8 grams of DI water were added to the vessel. The resulting mixture was stirred at 600 rpm for 30 minutes to insure homogeneity and filtered through a 75-µm filter media.
The filtered mixture was hand mixed with 354.9 grams of epoxy dispersion (Example 23) and letdown with 682.6 grams of DI water.

| Ingredient | Weight (%) |
|---|---|
| Oligomer Dispersion | 47.95 |
| Filler Slurry | 13.75 |
| Thixotrope: Silysia 440 | 2.0 |
| DI water | 3.25 |
| Epoxy Dispersion | 11.30 |
| Letdown DI water | 21.75 |

### Example 27:

In a one-gallon mixing vessel, 1463.9 grams of oligomer dispersion (Example 13) was loaded. Under high-shear mixing at 600 rpm using a Cowles type disperser, 326.8 grams of Aerosil 200 dispersion (Example 18), and 608.7 grams of Monomer Slurry (Example 19) were added to the vessel. The resulting mixture was stirred at 600 rpm for 30 minutes to insure homogeneity and filtered through a 75-µm filter media.
The filtered mixture was hand mixed with 189.6 grams of Epirez 5003-W-55, 63.2 grams of Epirez 6006-W-70, and letdown with 631.8 grams of DI water.

| Ingredient | Weight (%) |
|---|---|
| Oligomer Dispersion | 47.35 |
| Aerosil Dispersion | 10.55 |
| Monomer Slurry | 19.65 |
| Epirez 5003-W-55 | 6.13 |
| Epirez 6006-W-70 | 2.04 |
| Letdown DI water | 14.28 |

### Example 28

In a one-gallon mixing vessel, 706.8 grams of oligomer dispersion (Example 14) was loaded. Under high-shear mixing at 600 rpm using a Cowles type disperser, 250.4 grams of filler slurry (Example 20), and 30.1 grams of Aerosil K-315 were added to the vessel. The resulting mixture was stirred at 600 rpm for 30 minutes to insure homogeneity and filtered through a 75-µm filter media.
The filtered mixture was hand mixed with 150.3 grams of epoxy dispersion (Example 23) and letdown with 337 grams of DI water.

| Ingredient | Weight (%) |
|---|---|
| Oligomer Dispersion | 47.47 |
| Filler Slurry | 17.43 |
| Thixotrope: Aerosil K-315 | 2.05 |
| Epoxy Dispersion | 10.20 |
| Letdown DI water | 22.85 |

### Testing

### Sample preparation:

A 3 mil thick layer of the composition according to example 24 was applied onto a 6" x 6" copper-clad epoxy laminate substrate, and subsequently dried for 35 minutes in air at 185° Fahrenheit (85°C). The dried coating was placed in intimate contact with a diazo-coated Mylar phototool, and exposed to 500 mJ of ultraviolet light under 22"Hg of vacuum. The Mylar phototool was removed and the exposed layer was developed in a standard commercial developer by washing for 60 seconds at 95° Fahrenheit (35°C) with a 1% Na₂CO₃ aqueous alkaline solution. The developed layer was finally heat-cured for 60 minutes at 300° Fahrenheit (149°C).
The same procedure was employed for preparing samples with the compositions of examples 25-28.

Properties of the printed circuit board coating compositions according to examples 24-28 are set forth in Table 1 (for test methods see further below):

**Table 1: properties of the printed circuit board coating compositions**

| | **Ex.24** | **Ex.25** | **Ex.26** | **Ex.27** | **Ex.28** |
|---|---|---|---|---|---|
| **processing properties** | | | | | |
| tack-dry hardness | O | O | O | O | O |
| Alkaline resistance | O | O | O | X | O |
| Stouffer step | 11 | 12 | 11 | 8 | 10 |
| hot air solder leveling | O | O | O | X | X |

| final properties | | | | | |
|---|---|---|---|---|---|
| surface anomalies | ○ | ○ | ○ | X | X |
| pencil hardness | 7H | 7H | 6H | 6H | 6H |
| adhesion | ○ | ○ | ○ | ○ | ○ |

| | | | | | |
|---|---|---|---|---|---|
| (O) - acceptable; (X) - poor | | | | | |

### Test methods:

### Tack-dry hardness

A coating was considered to be tack-free if, after the above-noted exposure to 500 mJ of UV light, the diazo-coated Mylar phototool could be removed from the layer without sticking or removal of the unexposed areas of the coating.

### Alkaline resistance

After the developing step during the sample preparation, the layer was analyzed with the naked eye for hazing and defects (e.g. craters in the surface). If the layer was hazy and/or contained a substantial amount of defects, the alkaline resistance was considered to be poor. If the layer was substantially clear and substantially absent defects, the alkaline resistance was considered acceptable.

### Photosensitivity: Stouffer step

Assessment of photosensitivity was made by exposing part of the composition through a 21-step Stouffer step wedge. The result was evaluated after the development step.

### Hot air solder leveling

After the heat curing step, part of the coated copper substrate was dipped in solder of 460 °F (238°C) for 5 seconds. The coated substrate was then removed from the solder and the surface cured layer was analyzed with the naked eye for hazing. If the surface exhibited substantial hazing, then the hot air solder leveling was considered poor, if the surface was substantially absent any hazing, then the hot air solder leveling was considered acceptable.

### Surface anomalies

After the heat curing step, the surface of the layer was checked for anomalies (e.g. pinholes, craters, and dimples) with the naked eye. If the surface was substantially absent anomalies, the amount of surface anomalies was considered acceptable. If the surface contained a substantial amount of anomalies (e.g. more than 10 pinholes/craters/dimples), the amount of surface anomalies was considered to be poor.

### Pencil Hardness

Pencil Hardness of the heat-cured layer was determined according to TM 2.4.27.2 of IPC-TM-650, and evaluated according to the criteria defined in IPC-SM-840C, 3.5.1.

### Adhesion

Adhesion of the heat-cured layer to the copper substrate was determined according to TM 2.4.28.1 of IPC-TM-650, and evaluated according to the criteria defined in IPC-SM-840C, 3.5.2.

Having described specific embodiments of the present invention, it will be understood that many modifications thereof will readily be apparent to those skilled in the art, and it is intended therefore that this invention is limited only by the following claims.

## Claims

1. A printed circuit board coating composition comprising:
(a) one or more thermosetting components;
(b) one or more photoreactive components;
(c) one or more photoinitiators;
(d) water; and
at least one of the following ingredients(1)- (2):
(1) a thermosetting component comprising
one or more thermosetting groups, and
a polyether surfactant ;
(2) a photoreactive component comprising
at least two ethylenically unsaturated groups, and
a polyether surfactant.

2. The composition of claim 1, wherein said thermosetting component of ingredient (1) is prepared by reacting one or more polyether surfactants having an epoxy-reactive group with an epoxy resin with one or more epoxides.

3. The composition according to any one of claims 1-2, wherein said photoreactive component of said ingredient (2) is prepared by
(i) reacting one or more polyether surfactants having an epoxy-reactive group with an epoxy resin with one or more epoxides to form an epoxy-functional component comprising a surfactant ;
(ii) (meth)acrylating said epoxy-functional component obtained in step (i) with an ethylenically unsaturated acid; and
(iii) optionally, acidifying the (meth)acrylated epoxy-functional component obtained in step (ii) with a dicarboxylic acid or an anhydride.

4. The composition according to any one of claims 1-3, wherein said one or more thermosetting components includes said ingredient (1).

5. The composition according to any one of claims 1-4, wherein said one or more photoreactive components includes said ingredient (2).

6. The composition according to any one of claims 1-5, wherein said ingredient (1) has a molecular weight of at least 500 g/mol.

7. The composition according to any one of claims 1-6, wherein said ingredient (2) is prepared by a process comprising:
(i) first reacting an epoxy-functional component comprising at least two epoxy groups with a polyether surfactant comprising at least one epoxy-reactive group;
(ii) after step (i), reacting the epoxy-functional component with an unsaturated monocarboxylic acid; and
(iii) after step (ii), reacting the obtained unsaturated component with a saturated or unsaturated polybasic anhydride.

8. The composition of claim 7, wherein said epoxy component comprising at least two epoxy groups is an epoxy resin selected from the group consisting of bisphenol-A type epoxy resin, bisphenol-F type epoxy resin, tetraphenolethane type epoxy resin, phenolic novolac epoxy resin, bisphenol-A novolac epoxy resin, o-cresol epoxy novolac epoxy resin, trisphenol novolac epoxy resins, and cycloaliphatic epoxy resins.

9. The composition according to any one of claims 7-8, wherein said polyether surfactant comprising at least one epoxy-reactive group is a polyether surfactant selected from the group consisting of random or block-copolymer ethylene-oxide propylene oxide surfactants terminated on a least one terminus with isocyanate, hydroxyl, methoxy and/or carboxy functionality.

10. The composition of claim 9, wherein said polyether surfactant has a weight average molecular weight of 500-50,000g/mol.

11. The composition of claim 10, wherein said molecular weight is in the range of 5000- 20,000 g/mol.

12. The composition according to any one of claims7-11, wherein said unsaturated monocarboxylic acid is selected from the group consisting of acrylic acid and methacrylic acid.

13. The composition according to any one of claims 7-12, wherein said epoxy-functional component is reacted in said step (ii) with 0.5 to 1.1 equivalents of said unsaturated monocarboxylic acid.

14. The composition according to any one of claims 7-13, wherein said saturated or unsaturated polybasic acid anhydride is selected from the group consisting of phthalic anhydride, succinic anhydride, maleic anhydride and/or tetrahydrophthalic anhydride.

15. The composition according to any one of claims 7-14, wherein said obtained unsaturated component is reacted in said step (iii) with 0.5 to 1.0 equivalents of said saturated or unsaturated polybasic acid anhydride.

16. A process for coating a printed circuit board, comprising:
(i) applying the composition according to any one of claims 1-15 onto a printed circuit board;
(ii) exposing areas of the composition to radiation to form a radiation-cured pattern;
(iii) removing unexposed areas of the composition from the printed circuit board; and
(iv) exposing said radiation-cured pattern to heat.

17. The process according of claim 16, further comprising removing the water from the composition after applying the composition onto the printed circuit board.

18. The process of claim 17, wherein said water is removed at a temperature in the range of 50-90°C.

19. The process according to any one of claims 16-18, wherein said unexposed areas are removed with an aqueous alkaline solution.

20. The process according to any one of claims 16-19, wherein said radiation-cured coating is exposed to a temperature in the range of 125-200°C.

21. A printed circuit board comprising a coating obtained by a process comprising curing the composition according to any one of claims 1-15.

22. A printed circuit board comprising a coating obtained with the process according to any one of claims 16-20.

## Patentansprüche

1. Beschichtungszusammensetzung für Leiterplatten, umfassend:
(a) einen oder mehrere wärmehärtende Bestandteile;
(b) einen oder mehrere photoreaktive Bestandteile;
(c) einen oder mehrere Photoinitiatoren;
(d) Wasser; und
mindestens einen der folgende Bestandteile (1) bis (2):
(1) einen wärmehärtenden Bestandteil, umfassend einen oder mehrere wärmehärtende Gruppen, und ein Polyethertensid;
(2) einen photoreaktiven Bestandteil, umfassend: mindestens zwei ethylenisch ungesättigte Gruppen, und ein Polyethertensid.

2. Zusammensetzung nach Anspruch 1, wobei der wärmehärtende Bestandteil von Bestandteil (1) durch Umsetzen eines oder mehrerer Polyethertenside, die eine epoxyreaktive Gruppe aufweisen, mit einem Epoxyharz mit einem oder mehreren Epoxiden hergestellt wird.

3. Zusammensetzung nach einem der Ansprüche 1 bis 2, wobei der photoreaktive Bestandteil von Bestandteil (2) hergestellt wird durch
(i) Umsetzen eines oder mehrerer Polyethertenside, die eine epoxyreaktive Gruppe aufweisen, mit einem Epoxyharz mit einem oder mehreren Epoxiden, um einen epoxyfunktionellen Bestandteil zu bilden, der ein Tensid umfasst;
(ii) (Meth) acrylieren des epoxyfunktionellen Bestandteiles, der in Schritt (i) erhalten wird, mit einer ethylenisch ungesättigten Säure; und
(iii) optional, Säuern des (meth)acrylierten epoxyfunktionellen Bestanteils, der in Schritt (ii) erhalten wird, mit einer Dicarbonsäure oder einem Anhydrid.

4. Zusammensetzung nach einem der Ansprüche 1 bis 3, wobei der eine oder die mehreren wärmehärtenden Bestandteile den Bestandteil (1) aufweisen.

5. Zusammensetzung nach einem der Ansprüche 1 bis 4, wobei der eine oder die mehreren photoreaktiven Bestandteile den Bestandteil (2) aufweisen.

6. Zusammensetzung nach einem der Ansprüche 1 bis 5, wobei der Bestandteil (1) ein Molekulargewicht von mindestens etwa 500 g/Mol aufweist.

7. Zusammensetzung nach einem der Ansprüche 1 bis 6, wobei der Bestandteil (2) durch ein Verfahren hergestellt wird, das Folgendes umfasst:
(i) zuerst das Umsetzen eines epoxyfunktionellen Bestandteils, der mindestens zwei Epoxygruppen umfasst, mit einem Polyethertjensid, das mindestens eine epoxyreaktive Gruppe umfasst;
(ii) nach Schritt (i) das Umsetzen des epoxyfunktionellen Bestandteils mit einer ungesättigten Monocarbonsäure; und
(iii) nach Schritt (ii) das Umsetzen des erhaltenen ungesättigten Bestandteils mit einem gesättigten oder ungesättigten mehrbasischen Anhydrid.

8. Zusammensetzung nach Anspruch 7, wobei der Epoxybestandteil, der mindestens zwei Epoxygruppen umfasst, ein Epoxyharz ist, das ausgewählt ist aus der Gruppe, bestehend aus Bisphenol-A-artigem Epoxyharz, Bisphenol-F-artigem Epoxyharz, Itetraphenolethanartigem Epoxyharz, Phenolnovolac-Epoxyharz, Bisphenol-A-Novolac-Epoxyharz, O-Cresolepoxynovolac-Epoxyharz, Trisphenolnovolac-Epoxyharzen und zykloaliphatischen Epoxyharzen.

9. Zusammensetzung nach einem der Ansprüche 7 bis 8, wobei das Polyethertensid, das mindestens eine epoxyreaktive Gruppe umfasst, ein Polyethertensid ist, das ausgewählt ist aus der Gruppe, bestehend aus statistischen oder Blockoopolymer-Ethylenoxid-Propylenoxid-Tensiden, die auf mindestens einem Endpunkt mit Isocyanat, Hydroxyl, einer Methoxy- und/oder Carboxyfunktionalität abgeschlossen sind.

10. Zusammensetzung nach Anspruch 9, wobei das Polyethertensid ein durchschnittliches Molekulargewicht von 500 bis 50.000 g/Mol aufweist.

11. Zusammensetzung nach Anspruch 10, wobei das Molekulargewicht im Bereich von 5.000 bis 20.000 g/Mol liegt.

12. Zusammensetzung nach einem der Ansprüche 7 bis 11, wobei die ungesättigte Monocarbonsäure ausgewählt ist aus der Gruppe, bestehend aus Acrylsäure Methacrylsäure.

13. Zusammensetzung nach einem der Ansprüche 7 bis 12, wobei der epoxyfunktionelle Bestandteil in Schritt (ii) mit 0,5 bis 1,1 Äquivalenten der ungesättigten Monocarbonsäure umgesetzt wird.

14. Zusammensetzung nach einem der Ansprüche 7 bis 13, wobei das gesättigte oder ungesättigte mehrbasische Säureanhydrid ausgewählt ist aus der Gruppe, bestehend aus Phthalsäureanhydrid, Bernsteinsäureanhydrid, Maleinsäureanhydrid, und/oder Tetrahydrophthalsäureanhydrid.

15. Zusammensetzung nach einem der Ansprüche 7 bis 14, wobei der erhaltende ungesättigte Bestandteil in Schritt (iii) mit 0,5 bis 1,0 Äquivalenten des gesättigten oder ungesättigten mehrbasischen Säureanhydrids umgesetzt wird.

16. Verfahren zum Beschichten einer Leiterplatte, umfassend:
(i) Aufbringen der Zusammensetzung nach einem der Ansprüche 1 bis 15 auf eine Leiterplatte;
(ii) Aussetzen von Bereichen der Zusammensetzung einer Strahlung, um ein durch Strahlung gehärtetes Muster zu bilden;
(iii) Entfernen der nicht ausgesetzten Bereiche der Zusammensetzung von der Leiterplatte; und
(iv) Wärmeaussetzen des durch Strahlung gehärteten Musters.

17. Verfahren nach Anspruch 16, ferner umfassend das Entfernen des Wassers von der Zusammensetzung nach Aufbringen der Zusammensetzung auf die Leiterplatte.

18. Verfahren nach Anspruch 17, wobei das Wasser bei einer Temperatur im Bereich von 50 bis 90 °C entfernt wird.

19. Verfahren nach einem der Ansprüche 16 bis 18, wobei die nicht ausgesetzten Bereiche mit einer wässrigen alkalischen Lösung entfernt werden.

20. Verfahren nach einem der Ansprüche 16 bis 19, wobei die durch Strahlung gehärtete Beschichtung einer Temperatur im Bereich von 125 bis 20C °C ausgesetzt wird.

21. Leiterplatte, umfassend eine Beschichtung, die durch ein Verfahren erhalten wird, welches das Härten der Zusammensetzung nach einem der Ansprüche 1 bis 15 umfasst.

22. Leiterplatte, umfassend eine Beschichtung, die mit dem Verfahren nach einem der Ansprüche 16 bis 20 erhalten wird.

## Revendications

1. Composition de revêtement de carte de circuit imprimé, comprenant :
(a) un ou plusieurs composants thermodurcissables ;
(b) un ou plusieurs composants photoréactifs ;
(c) un ou plusieurs photo-initiateurs ;
(d) de l'eau ; et
au moins l'un des ingrédients (1)-(2) suivants :
(1) un composant thermodurcissable comprenant un ou plusieurs groupes thermodurcissables et un agent tensioactif polyéther ;
(2) un composant photoréactif comprenant au moins deux groupes éthyléniquement insaturés, et
un agent tensioactif polyéther.

2. Composition selon la revendication 1, dans laquelle ledit composant thermodurcissable de l'ingrédient (1) est préparé en faisant réagir un ou plusieurs agents tensioactifs polyéther présentant un groupe époxy-réactif avec une résine époxy présentant un ou plusieurs époxydes.

3. Composition selon l'une quelconque des revendications 1-2, dans laquelle ledit composant photoréactif dudit ingrédient (2) est préparé
(i) en faisant réagir un ou plusieurs agents tensioactifs polyéther présentant un groupe époxy-réactif avec une résine époxy présentant un ou plusieurs époxydes de manière à former un composant à fonctionnalité époxy comprenant un agent tensioactif ;
(ii) en (méth)acrylant ledit composant à fonctionnalité époxy obtenu dans l'étape (i) avec un acide éthyléniquement insaturé ; et
(iii) éventuellement, en acidifiant le composant (méth)acrylé à fonctionnalité époxy obtenu dans l'étape (ii) avec un acide dicarboxylique ou un anhydride.

4. Composition selon l'une quelconque des revendications 1-3, dans laquelle ledit un ou lesdits plusieurs composants thermodurcissables comprennent ledit ingrédient (1).

5. Composition selon l'une quelconque des revendications 1-4, dans laquelle ledit un ou lesdits plusieurs composants photoréactifs comprennent ledit ingrédient (2).

6. Composition selon l'une quelconque des revendications 1-5, dans laquelle ledit ingrédient (1) présente un poids moléculaire d'au moins 500 g/mole.

7. Composition selon l'une quelconque des revendications 1-6, dans laquelle ledit ingrédient (2) est préparé par un procédé dans lequel :
(i) on fait d'abord réagir un composant à fonctionnalité époxy comprenant au moins deux groupes époxy avec un agent tensioactif polyéther comprenant au moins un groupe époxy-réactif ;
(ii) après l'étape (i), on fait réagir le composant à fonctionnalité époxy avec un acide monocarboxylique insaturé ; et
(iii) après l'étape (ii), on fait réagir le composant insaturé obtenu avec un anhydride polybasique saturé ou insaturé.

8. Composition selon la revendication 7, dans laquelle ledit composant époxy comprenant au moins deux groupes époxy est une résine époxy choisie dans le groupe constitué par une résine époxy de type bisphénol-A, une résine époxy de type bisphénol-F, une résine époxy de type tétraphénoléthane, une résine époxy phénolique novolaque, une résine époxy bisphénol-A novolaque, une résine époxy o-crésol époxy novolaque, les résines époxy trisphénol novolaque, et les résines époxy cycloaliphatiques.

9. Composition selon l'une quelconque des revendications 7-8, dans laquelle ledit agent tensioactif polyéther comprenant au moins un groupe époxy-réactif est un agent tensioactif polyéther choisi dans le groupe constitué par des agents tensioactifs à base de copolymères aléatoires ou à blocs d'oxyde d'éthylène-oxyde de propylène terminés en au moins une extrémité par une fonctionnalité isocyanate, hydroxyle, méthoxy et/ou carboxy.

10. Composition selon la revendication 9, dans laquelle ledit agent tensioactif polyéther présente un poids moléculaire pondéral moyen de 500-50 000 g/mole.

11. Composition selon la revendication 10, dans laquelle ledit poids moléculaire est situé dans la plage de 5 000-20 000 g/mole.

12. Composition selon l'une quelconque des revendications 7-11, dans laquelle ledit acide monocarboxylique insaturé est choisi dans le groupe constitué par l'acide acrylique et l'acide méthacrylique.

13. Composition selon l'une quelconque des revendications 7-12, dans laquelle on fait réagir ledit composant à fonctionnalité époxy dans ladite étape (ii) avec 0,5 à 1,1 équivalent dudit acide monocarboxylique insaturé.

14. Composition selon l'une quelconque des revendications 7-13, dans laquelle ledit anhydride d'acide polybasique saturé ou insaturé est choisi dans le groupe constitué par l'anhydride phtalique, l'anhydride succinique, l'anhydride maléique et/ou l'anhydride tétrahydrophtalique.

15. Composition selon l'une quelconque des revendications 7-14, dans laquelle on fait réagir ledit composant insaturé obtenu dans ladite étape (iii) avec 0,5 à 1,0 équivalent dudit anhydride d'acide polybasique saturé ou insaturé.

16. Procédé pour revêtir une carte de circuit imprimé, comprenant :
(i) l'application de la composition selon l'une quelconque des revendications 1-15 sur une carte de circuit imprimé ;
(ii) l'exposition de zones de la composition à une radiation de manière à former un motif durci par radiation ;
(iii) l'élimination de zones non exposées de la composition de la carte de circuit imprimé ; et
(iv) l'exposition dudit motif durci par radiation à la chaleur.

17. Procédé selon la revendication 16, comprenant en outre l'élimination de l'eau de la composition après l'application de la composition sur la carte de circuit imprimé.

18. Procédé selon la revendication 17, dans lequel ladite eau est enlevée à une température située dans la plage de 50-90°C.

19. Procédé selon l'une quelconque des revendications 16-18, dans lequel lesdites zones non exposées sont enlevées par une solution aqueuse alcaline.

20. Procédé selon l'une quelconque des revendications 16-19, dans laquelle ledit revêtement durci par radiation est exposé à une température dans la plage de 125-200°C.

21. Carte de circuit imprimé comprenant un revêtement obtenu par un procédé comprenant le durcissement de la composition selon l'une quelconque des revendications 1-15.

22. Carte de circuit imprimé comprenant un revêtement obtenu par le procédé selon l'une quelconque des revendications 16-20.
